Europäisches Patentamt

European Patent Office

Office européen des brevets

(11) Publication number: **0 467 244 A1**

# EUROPEAN PATENT APPLICATION

(21) Application number: **91111706.7**

(22) Date of filing: **13.07.91**

(51) Int. Cl.5: **H01L 27/08, H01L 27/02**

(30) Priority: **18.07.90 JP 188024/90**

(43) Date of publication of application:
**22.01.92 Bulletin 92/04**

(84) Designated Contracting States:
**DE GB**

(71) Applicant: **MATSUSHITA ELECTRIC INDUSTRIAL CO., LTD.**
**1006, Oaza Kadoma**
**Kadoma-shi, Osaka-fu, 571(JP)**

(72) Inventor: **Sadamatsu, Hideaki**
**39-13, Nasuzukurihigashi-machi**
**Hirakata-shi, Osaka-fu(JP)**

(74) Representative: **Eisenführ, Speiser & Strasse**
**Martinistrasse 24**
**W-2800 Bremen 1(DE)**

(54) **Semiconductor integrated circuit.**

(57) The present invention relates to a semiconductor integrating circuit, where a plurality of areas of an n-type of conductive type are provided on the P-type of conductive type basic plate, with the p-type of resistance area being connected with the n-type area, so that, in order to prevent the thyristor phenomenon from being caused, and the latch up from being caused, the base of the PNP transistor constructing the thyristor is adapted to be connected with the emitter.

*Fig. la*

## BACKGROUND OF THE INVENTION

The present invention generally relates to a high quality of semiconductor integrating circuit, and more particularly, to a semiconductor integrating circuit which is less in latch up.

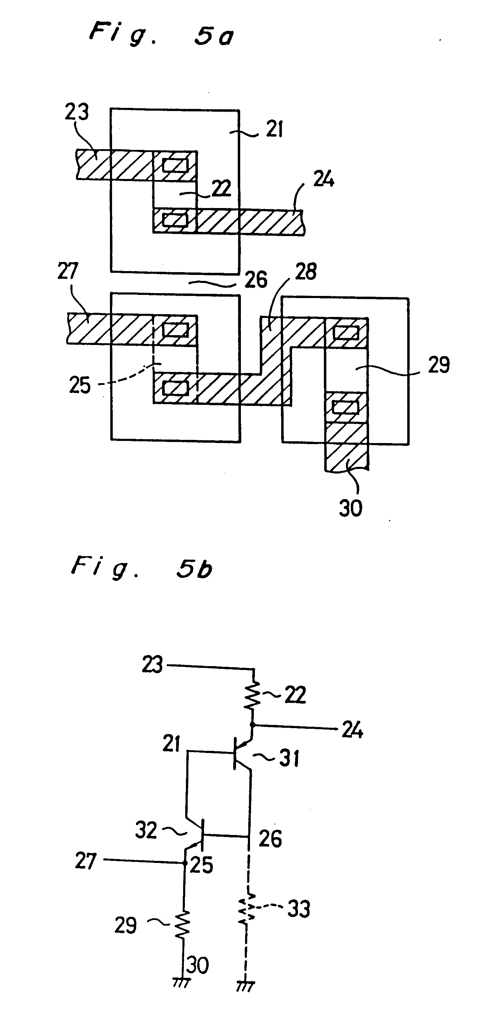

In the conventional semiconductor integrating circuit, one resistor is provided on one island as shown in Fig. 5 so as to increase the integration degree without taking the electric potential of the island. The description will be effected hereinafter in accordance with the Fig. 5. Fig. 5 (a) is a pattern chart and Fig. 5 (b) shows an equivalent circuit diagram. Reference numeral 21 is an n-type island area, reference numeral 22 is a p-type resistance area within the n-type island area 21, reference numerals 23, 24 are electrodes taken out from the p-type resistance area 22, with reference numeral 23 being provided on the higher electric potential side. Reference numeral 25 is an n-type island area, reference numeral 26 is a p-type separating area for separating the n-type island area 21 from the n-type island area 25, reference numerals 27, 28 are electrodes taken out of the n-type island area 25, are connected with an earth electrode 30 through the p-type resistor 29 from the electrode 28. When one p-type resistance area 22 is placed within one n-type island area 21, the current does not flow between the n-type island area 21 and the p-type resistance area 22 even if the n-type island area 21 is kept floating. Therefore, the potential of the island area is not required to be taken. The integration degree can be increased from the following two points: (1) The connection area between the n-type island area 21 and the electrode is unnecessary, and (2) the connection pattern between the high potential (power supply voltage) and the n-type island area 21 is unnecessary.

In such a case as shown in Fig. 5 (a), namely, when the n-type island area 25 is closer to the n-type island area 21 with the other of the p-type resistor 29 connected with the n-type island area 25 being earthed, a parasitic PNP transistor 31 where the p-type resistance area 22, the n-type island area 21 and the p-type separation area 26 are respectively made an emitter • a base • a collector, and a parasitic NPN transistor 32 where the n-type island area 21, the p-type separation area 26, and the n-type island area 25 are respectively made a collector • a base • an emitter are formed and become a thyristor of PNPN construction. The p-type separation area 26 is away from the earth, thus resulting in a resistor additionally provided between the p-type separation area 26 and the earth. The equivalent circuit is shown in Fig. 5 (b). When the p-type separation area 26 is away from the earth, the potential becomes higher so as to turn on the parasitic NPN transistor 32.

When the parasitic NPN transistor 32 is turned on, the collector current of the parasitic PNP transistor 31, namely, the base current of the parasitic PNP transistor 31 flows. The parasitic PNP transistor 31 turns on flows into the collector of the parasitic PNP transistor 31 the current of $h_{FE}$ magnification of the base current. The base potential of the parasitic NPN transistor 32 is further raised by the resistor 33 and more currents are flowed. As a result, the current is increased until the parasitic PNP transistor 31, the parasitic NPN transistor 32 are saturated. Especially when a resistor 33 is small, or does not exist, the expressive current comes to flow. This is likely to be caused especially in the case of the PNPN.

## SUMMARY OF THE INVENTION

Accordingly, the present invention has been developed with a view to substantially eliminating the above discussed drawbacks inherent in the prior art, and has for its essential object to provide an improved semiconductor integrating circuit which is capable of circuit construction without latch up simply with extremely simple circuit construction and small amount of area addition.

In accomplishing these and the objects, according to one preferred embodiment of the present invention, there is provided a semiconductor integrating circuit which connects the base of the parasitic PNP transistor with the emitter or with one portion of the resistor connected with the emitter to turn the base potential into the emitter potential or more so that the operation of the parasitic PNP transistor may not be effected.

By the above describe construction, the base current of the parasitic PNP transistor becomes zero, and the collector current becomes zero, either. Therefore, the voltage of the parasitic resistance between the collector of the parasitic PNP transistor and the earth becomes smaller, the base potential of the parasitic NPN transistor becomes lower, so that the parasitic NPN transistor is not turned on. Therefore, as the parasitic NPN transistor current does not flow, either, the latch up is not caused.

## BRIEF DESCRIPTION OF THE DRAWINGS

These and other objects and features of the present invention will become apparent from the following description taken in conjunction with the preferred embodiment thereof with reference to the accompanying drawings, in which;

Fig. 1, Fig. 2, Fig. 3, Fig. 4 are circuit diagrams of a semiconductor integrating circuit in the embodiment of the present invention, with the (a) thereof being a surface pattern chart, and the (b) thereof being an equivalent circuit chart; and

Fig. 5 is a circuit diagram of the conventional semiconductor integrating circuit, with the (a) thereof being a surface pattern and the (b) thereof being an equivalent circuit diagram.

DETAILED DESCRIPTION OF THE INVENTION

Before the description of the present invention proceeds, it is to be noted that like parts are designated by like reference numerals throughout the accompanying drawings.

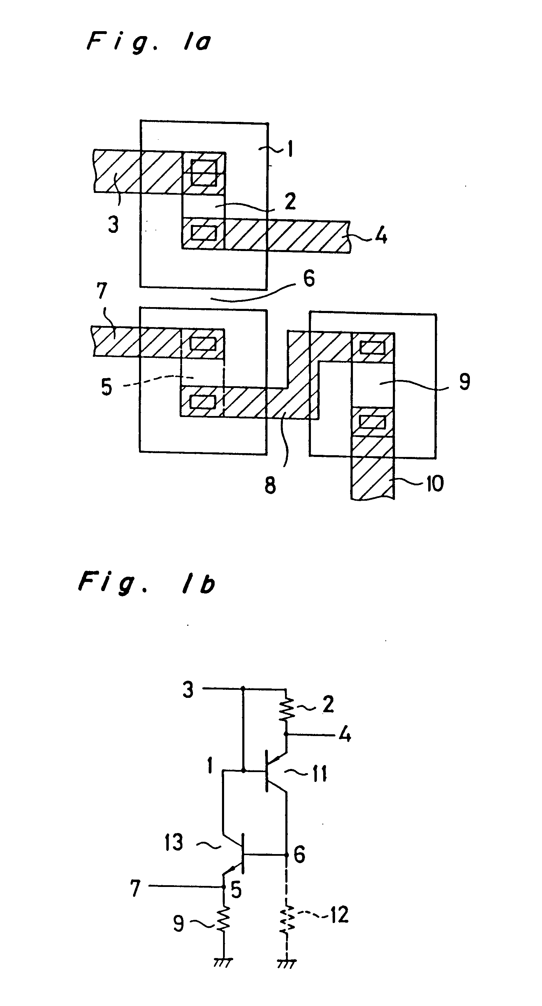

Referring now to the drawings, there is shown in Fig. 1, a semiconductor integrating circuit according to one preferred embodiment of the present invention, with the (a) thereof showing the surface pattern chart and the (b) thereof showing the equivalent circuit diagram.

Reference numeral 1 is an n-type island area, reference numeral 2 is a p-type resistance area, reference numeral 3 is an electrode with the n-type island area 1 being connected with the high potential side of the p-type resistance area 2, reference numeral 4 is a low potential side electrode of the p-type resistance area 2, reference numeral 5 is an n-type island area, reference numeral 6 is a p-type separation area for separating the n-type island area 1 from the n-type island area 5, reference numerals 7, 8 are electrodes for connecting the n-type island areas, reference numeral 9 is a resistor for connecting the n-type island area with the earth electrode 10. The equivalent circuit diagram (b) shows the equivalent circuit of the pattern chart (a), with the numerals of the respective areas and the positional numerals of the equivalent circuit being unified. Since the base of the parasitic PNP transistor 11 is connected with the electrode on the high potential side of the p-type resistance area 2, the base potential becomes higher than the emitter potential, with the parasitic PNP transistor 11 being turned off. Therefore, as the current does not flow into the resistor 12 and the potential of the p-type separating area 6 of the parasitic NPN transistor 13 is low, the NPN transistor 13 is also turned off. Therefore, the current does not flow, thus causing no latch up.

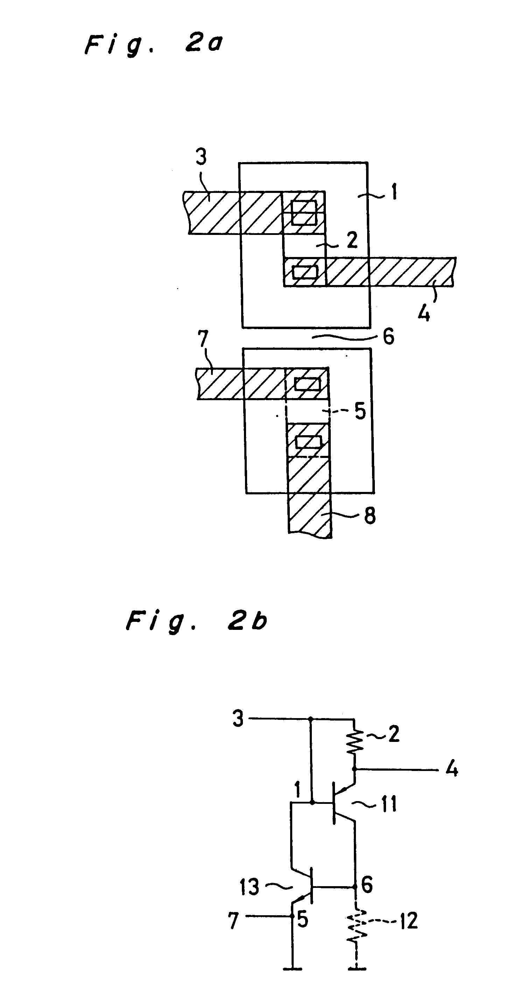

Fig. 2 shows a second embodiment of the present invention, with numerals 1 through 8 being similar to those of Fig. 1. In the case of the embodiment, although the emitter of the parasitic NPN transistor 13 is directly earthed, the latch up is not caused as in Fig. 1.

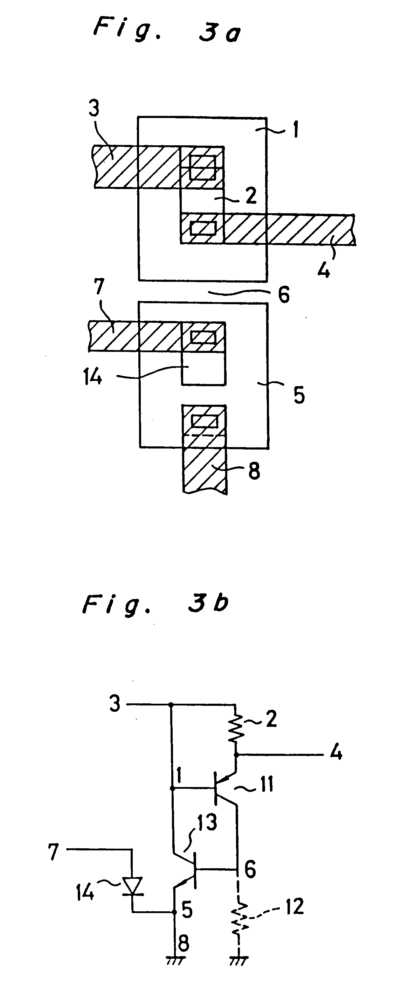

Fig. 3 shows a third embodiment of the present invention, with the numerals 1 through 8 being similar to those of Fig. 1. Reference numeral 14 is a p-type diffusion area formed within the n-type island area 5, with the diode being equivalently connected. The latch up may be prevented similarly even in a case where the diode exists.

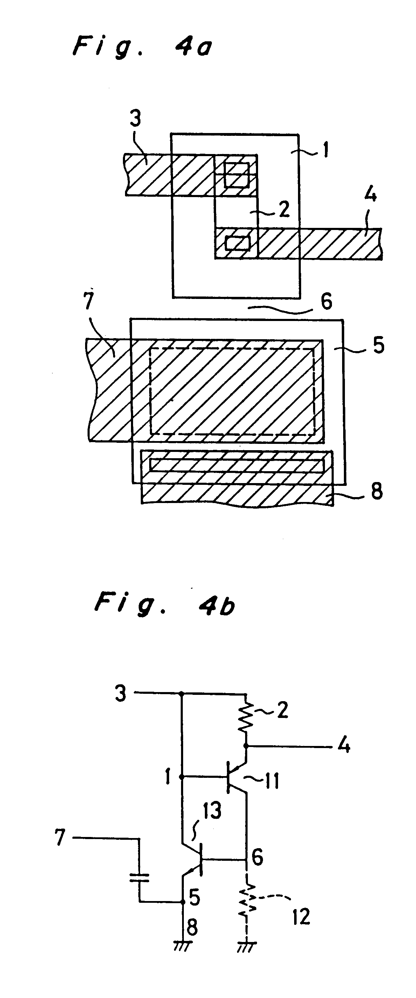

Fig. 4 shows a fourth embodiment of the present invention, with the numerals 1 through 8 being similar to those of Fig. 1. This is a case where the electrode is provided on the n-type island area 5, a capacitor is composed between the n-type island area 5 and the electrode 7.

Although the emitter of the parasitic NPN transistor 13 is directly earthed in the third, fourth embodiment, the same thing can be said even in a case where the resistor is connected between the emitter of the NPN transistor 13 and the earth 13.

As is clear from the foregoing description, according to the arrangement of the present invention, only by the extremely simple circuit construction and the small area addition, the circuit construction without the latch up may be effected, and the semiconductor integrating circuit which is higher in quality and reliability is obtained, with larger effects in the practical use.

Although the present invention has been fully described by way of example with reference to the accompanying drawings, it is to be noted here that various changes and modifications will be apparent to those skilled in the art. Therefore, unless otherwise such changes and modifications depart from the scope of the present invention, they should be construed as included therein.

**Claims**

1. A semiconductor integrating circuit comprising a first island area of the other conductive type and a second island area of the other conductive type on one conductive type of basic plate, and a first diffusion resistance area of one conductive type within the first island area, no electrode to be earthed from the basic plate portion grasped between the first island area and the second island area with the first island area being close to the second island area, and having the potential of the first island area in the highest potential from among the electrodes to be connected with the first diffusion resistance area, with the second island area being earthed.

2. A semiconductor integrating circuit described in accordance with the claim 1 wherein a second resistor is provided between the second island area and the earth.

3. A semiconductor apparatus described in accordance with the claim 1 or 2, wherein a second diffusion area of one conductive type is provided in the second island area, with the second diffusion area being provided as anode, and the island area being provided as a cathode.

4. A semiconductor apparatus described in accordance with the claim 1 or 2, wherein a first electrode is arranged on the second island area, the first electrode and the second island area are provided as a capacitor.

Fig. 1a

Fig. 1b

Fig. 2a

Fig. 2b

*Fig. 3a*

*Fig. 3b*

Fig. 4a

Fig. 4b

# Fig. 5a

# Fig. 5b

European
Patent Office

EUROPEAN SEARCH
REPORT

Application Number

EP 91 11 1706

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| Y | IBM TECHNICAL DISCLOSURE BULLETIN. vol. 14, no. 4, September 1971, NEW YORK US pages 1075 - 1076; G.J. HADAMARD: 'Integrated circuits having reduced parasitic thyratron effects' <br> – – – | 1 | H 01 L 27/08 <br> H 01 L 27/02 |
| A | * page 1076, paragraph 1-3; figures A-C * <br> – – – | 2 | |
| Y | US-A-3 990 092   (HITACHI LTD.) <br> * column 1, line 31 - column 2, line 32 * * * column 3, line 31 - column 4, line 52 * * * column 5, line 51 - column 6, line 15; figures 1-2,3-5,7A-7C * * <br> – – – | 1 | |
| A | PATENT ABSTRACTS OF JAPAN vol. 7, no. 8 (E-152)(1153) 13 January 1983 <br> & JP-A-57 166 070 ( MATSUSHITA DENKI SANGYO K.K. ) 13 October 1982 <br> * abstract * * <br> – – – – – | 1 | |
| | | | TECHNICAL FIELDS SEARCHED (Int. Cl.5) |
| | | | H 01 L |

The present search report has been drawn up for all claims

| Place of search | Date of completion of search | Examiner |
|---|---|---|
| The Hague | 13 November 91 | FRANSEN L.J.L. |